# EUROPEAN PATENT SPECIFICATION

(11) **EP 3 426 828 B1**
(45) Date of publication and mention of the grant of the patent: **28.02.2024**
(21) Application number: 17763366.6
(22) Date of filing: 09.03.2017
(51) Int. Cl.: B01D 39/16, D04H 3/007, D01D 5/34, B01D 67/00, D01F 6/04, D01F 8/06, D04H 1/4291, B01D 71/26

(54) **LOW-ELUTION POLYETHYLENE-BASED FIBERS AND NONWOVEN FABRIC USING SAME**
FASERN AUF BASIS VON ELUTIONSARMEM POLYETHYLEN UND VLIESSTOFF DAMIT
FIBRES À BASE DE POLYÉTHYLÈNE À FAIBLE ÉLUTION ET TEXTILE NON-TISSÉ UTILISANT CELLES-CI

(30) Priority: 11.03.2016 JP 2016048669
(43) Date of publication of application: 16.01.2019
(73) Proprietor: ES FiberVisions Co., Ltd., Osaka-shi, Osaka 530-6108 (JP); ES Fibervisions Hong Kong Limited, Kowloon, Hong Kong (CN); ES FiberVisions LP, Athens, Georgia 30601 (US); ES FiberVisions ApS, 6800 Varde (DK)
(72) Inventor: MATSUDA, Yasushi, Osaka-shi Osaka 530-6108 (JP); TSUTSUI, Toshihiko, Osaka-shi Osaka 530-6108 (JP)
(74) Representative: Becker Kurig & Partner Patentanwälte mbB
(86) International application number: PCT/JP2017/009449
(87) International publication number: WO 2017/155026

(56) References cited:
- WO-A1-2011/158644
- JP-A- H0 655 044
- JP-A- 2000 317 280
- JP-A- 2010 234 344
- JP-B2- 3 677 197
- US-A1- 2002 034 635
- US-A1- 2011 259 818
- US-A1- 2015 209 735
- US-A1- 2015 299 903

## Description

### Technical Field

The invention relates to polyethylene-based fibers in which metal eluted from the fibers is reduced.

### Background Art

Next-generation technical innovation in a semiconductor industry is progressing. When a semiconductor pattern is fabricated, a KrF excimer laser with a wavelength of 248 nanometers, furthermore, a liquid-immersion ArF excimer laser with a wavelength of 193 nanometers or the like is currently used. However, in aiming at achieving further finer lines, study has been made on processing with a target line width of 7 nanometers by utilizing extreme ultraviolet lithography for a wavelength of 13.5 nanometers.

When such a fine pattern is fabricated, mixing of only a limited amount of particles or metal ions in a working environment causes defects, and therefore a resist liquid to be used or the like is filtered by using a filter with a significantly small pore diameter such as several nanometers to several tens of nanometers in pore diameter in many cases. In such a filter, a filter made of polymer is used in order to prevent elution of metal ions in many cases.

As a raw material of such a filter, polypropylene has so far been used because of chemical stability and easiness of thermal processing. However, polypropylene has a disadvantage of being easily oxidatively decomposed, and therefore only a limited amount of fine particles produced by oxidative decomposition may be occasionally mixed into a filtrate, or an antioxidant added to polypropylene for preventing the oxidative decomposition may be occasionally mixed into the filtrate. In order to improve the above problem, polyethylene that is by far scarcely oxidizable than polypropylene has been frequently used.

Polyethylene is superior to polypropylene in view of difficulty in being oxidatively decomposed, but several hundred ppm of metal-containing substance is kneaded in the form of residues of a polymerization catalyst or a gel inhibitor in many cases. Such a metal-containing substance is ordinarily rarely eluted from polyethylene. However, if polyethylene is exposed into a liquid having high solubility, such as the resist liquid for a long period of time, but polyethylene is eluted little by little. Only a limited amount of the metal-containing substance has been known to cause the defect, particularly in a step in which processing is made at a short wavelength.

Patent literature Nos. 1, 2 and 3 disclose polyethylene-based fibers, but describe nothing on an elution component from the fibers. A stabilizer is formulated in polyethylene produced by polymerization with a Ziegler-Natta catalyst to be ordinarily used, and therefore a metallic component is liable to be eluted, and such a material has not necessarily been sufficient as a filter application for filtering the resist liquid.

Patent literature No. 4 discloses a hollow fiber membrane module. A hollow fiber membrane module includes a hollow fiber membrane filter in which a plurality of hollow fiber membranes comprising polyolefin are bound and the side of the bound end parts of the hollow fiber membranes are potted. In the hollow fiber membrane module, the hollow fiber membrane is provided by additive-free polyolefin not containing an additive which elutes the inorganic substances and/or organic substances such as a neutralizing agent, an antioxidant, or a photostabilizer.

Patent literature No. 5 discloses a filter using an ultrahigh molecular weight polyethylene porous membrane as a filter medium. The ultrahigh molecular weight polyethylene porous membrane is produced by gelatinizing a molecular weight 4×10^5 or more ultrahigh molecular weight polyethylene solution to make a film, removing a solvent and then stretching to at least one direction to make porous. The polyethylene porous membrane having a thickness of 10-300 pm, a porosity of 30-90%, an average pore size of 0.03-5.0 µm, and a tensile strength of at least 10 MPa or more to one direction is laminated in a nonwoven fabric state due to fibrillation at a stretching time.

Patent literature No. 6 discloses a filter element. A filter element comprises an inner casing, an outer casing, a filter membrane disposed between the casings and net support bodies between which the filter membrane is inserted, and end caps. The filter membrane has a metal content of 40ppm or less and organic additive content consists of 1 wt% or less of a weight average molecular weight of 1,000,000 or more ultrahigh molecular weight polyethylene resin. Members other than the filter membrane has a metal content of 20ppm or less and an organic additive is not substantially added.

Patent literature No. 7 discloses a polyethylene powder for a fiber. An intrinsic viscosity of the polyethylene powder measured at 135° C in decalin is 10 dL/g or higher and 40 dL/g or lower. A total amount of Al, Mg, Ti, Zr, and Hf contained in the polyethylene powder is 1.0 ppm or higher and lower than 15 ppm. A amount of the polyethylene powder having a particle having a particle size exceeding 355 µm is 2.0% by mass or lower. An amount of the polyethylene powder having a particle having a particle size of 75 µm or smaller is 3.0% by mass or higher and 50.0% by mass or lower.

Patent literature NO. 8 discloses a filter made of fibers with a sheath-core structure containing low melting point polyethylene such as LLDPE and high melting point polyethylene such as HDPE. The linear low-density polyethylene has a density of 0.93g/cm³ and comprises a sheath component, and the high density polyethylene has a density of 0.96cm³ and comprises a core component. I

Patent literature NO. 9 discloses sheath-core conjugate fibers comprising a metallocene-catalysed polyethylene as a sheath component and a polyethylene obtained via a Ziegler-Natta catalyst as a core component. Said components are in a 50/50 weight ratio. The melt flow rate of the components is 30 and 40, respectively.

### [Citation List]

### [Patent Literature]

Patent literature No. 1: JP 2000-160428 A.
Patent literature No. 2: JP 2001-336033 A.
Patent literature No. 3: JP 2012-510570 A.
Patent literature No. 4: JP 2010-234344 A.
Patent literature NO. 5: JP 2000-317280 A.
Patent literature NO. 6: JP H06-55044 A.
Patent literature NO. 7: US 2015/0299903 A1.
Patent literature NO.- 8: JP 3 677197 B2.
Patent literature NO. 9: US 2002/034635 A1.

### [Summary of Invention]

### [Technical Problem]

Therefore, the invention is contemplated for providing polyethylene-based fibers in which elution of metal from polyethylene is suppressed as much as possible.

### [Solution to Problem]

The present inventors have diligently continued to conduct research in order to solve the problem described above, and as a result, have found that polyethylene-based fibers having a metal content of 40 ppm or less to be adaptable for the purpose thereof, and thus have completed the invention based on the finding.

A structure of the invention is as described below.

### [Advantageous Effects of Invention]

In polyethylene-based fibers of the invention, metal eluted from polyethylene is significantly small. Therefore, the polyethylene-based fibers of the invention can be preferably used as a material of a nonwoven fabric to be used in a process of manufacturing a photoresist or a semiconductor, for example.

### [Description of Embodiments]

Polyethylene-based fibers of the invention are composed of at least one kind of polyethylene resin, and a total of content of metal elements such as Na, K, Ca, Fe, Cu, Mg, Mn, Li, Al, Cr, Ni and Zn contained inside the fibers is 40 ppm or less.

An expression "a total of content of the metal elements contained inside the fibers as listed above is 40 ppm or less" means that a total of content of the above metal detected when an elution component extracted by a method described later is analyzed after washing a surfactant and so forth adhered onto a surface of the polyethylene-based fibers is 40 ppm or less based on mass of the polyethylene-based fibers.

The polyethylene-based fibers used in the invention are produced by using high density polyethylene, linear low density polyethylene and low density polyethylene which are broadly classified depending on segmentation of density and a melting point as described below.

The high density polyethylene herein means a product that is produced by polymerization according to a low-pressure process by using a publicly known catalyst, and a polymer of ethylene alone or a copolymer of ethylene and higher alkene having 3 to 12 carbons in a proportion of 2% by weight at a maximum, and the product having density of 0.94 g/cm³ or more, and a melting point of 127°C or higher, in general.

The linear low density polyethylene herein means a product that is produced by polymerization by using a publicly known catalyst, and a copolymer of ethylene and higher alkene having 3 to 12 carbons ordinarily in a proportion of 15% by weight or less without substantially having a long branched chain, and the product having density of 0.925 g/cm³ or more and less than 0.940 g/cm³, and a melting point of lower than 127°C ethylene, in the case of a Ziegler-Natta catalyst, in general. In the case of a metallocene catalyst, the linear low density polyethylene means a product having density of 0.900 g/cm³ or more and less than 0.940 g/cm³, and a melting point of lower than 127°C.

The low density polyethylene herein means polyethylene that is produced by polymerization according to a high-pressure process, has many branched chains and low crystallinity, and density of 0.91 g/cm³ or more and less than 0.925 g/cm³, and a melting point of 120°C or lower, in general.

The polyethylene resin that can be used as a raw material of the polyethylene-based fibers of the invention is not limited by a production method, a catalyst or the like, as long as the resin has only a limited amount of metal elements eluted from the resin. However, for example, such a resin can be preferably used as the resin in which a stabilizing agent such as a neutralizer, an antioxidant and an ultraviolet-light inhibitor is added in an amount as low as possible, or the resin to which no stabilizer is added. In particular, the polyethylene resin produced by polymerization by using the metallocene catalyst can also be preferably used as the raw material of the fibers of the invention. The resin has a melting point lower than the melting point of the polyethylene resin produced by polymerization by using the Ziegler-Natta catalyst, and therefore is advantageous in view of low temperature processability when the fibers are thermally bonded with each other, and simultaneously has a narrow molecular weight distribution, which significantly contributes to spinning stability, and therefore can be preferably used. Moreover, the polyethylene resin produced by polymerization by using the metallocene catalyst has a lower amount of halogen element used in the catalyst than the amount in the polyethylene resin produced by polymerization by using the Ziegler-Natta catalyst, and therefore addition of calcium stearate being the neutralizer or the like can be significantly reduced. Thus, the content of metal is low, and the content of the stabilizing agent or the like is also low. Therefore, the fibers in which a metal amount contained inside the fibers is small and an elution amount from the fibers is small can be obtained by constituting the polyethylene-based fibers by using the polyethylene resin produced by polymerization by using the metallocene catalyst.

The polyethylene-based fibers of the invention have a feature of a smaller content of metal contained in the fibers than ever before. The polyethylene-based fibers of the invention may be fibers composed of a single component, or conjugate fibers in which a plurality of components are conjugated.
Specific examples of the polyethylene-based fibers composed of the single component include fibers composed of the high density polyethylene, and fibers composed of the linear low density polyethylene. Moreover, as the resin serving as the raw material of the conjugate fibers, if any resin in which the difference in the melting point becomes 5°C or more is applied among the high density polyethylene, the linear low density polyethylene and the low density polyethylene, any resin can be arbitrarily combined as a first component and a second component.

As a conjugation form of a combination of the first component and the second component as described above, the components can be formed into conjugate fibers of a side-by-side type, a sheath-core type, an eccentric sheath-core type, a multilayer type or a sea-island type. For example, specific examples of the combination of the sheath-core conjugate fibers composed of the first component (core component) and the second component (sheath component) include conjugate fibers in which a first component (core component) is composed of a polyethylene resin having density of 0.94 g/cm³ or more, a second component (sheath component) is composed of a polyethylene resin having density of 0.90 g/cm³ or more, and the density of the first component (core component) is higher than the density of the second component (sheath component). Specific examples of the combination include a combination of high density polyethylene and linear low density polyethylene, a combination of high density polyethylene and low density polyethylene, and a combination of linear low density polyethylene and low density polyethylene.

As a means of producing the polyethylene-based fibers of the invention, a publicly known melt spinning process and an apparatus thereof can be applied. A melt flow rate (hereinafter, abbreviated as MFR) of the high density polyethylene, the linear low density polyethylene and the low density polyethylene used in the melt spinning process is generally in the range of 2 to 50 g/10 min, and preferably 10 to 40 g/10 min. In addition, MFR (g/10 min) herein is expressed in terms of a value measured in accordance with JIS K7210 (190°C, 2160 g). If the amount of the stabilizing agent is small, instability of spinning by gelation or the like is easily caused generally upon producing the fibers. Therefore, upon production, extrusion conditions under which gel is hard to form (low-temperature extrusion, screw shape, spinneret filter) are applied, which can reduce fiber breakage or the like during spinning to contribute to stabilization of spinning.

When the conjugate fibers are produced, a weight ratio of the first component to the second component in the fibers is preferably 30:70 to 70:30, and further preferably in the range of 40:60 to 60:40 in view of productivity. Moreover, the difference in the melting point between two components used as the raw material of the conjugate fibers is preferably 5°C or more. The melting point difference herein means a difference in temperature between a peak on a high melting point side and a peak on a lower melting point side to ne observed on a DSC curve obtained when the fibers of the invention are analyzed by a differential scanning calorimeter. If the difference in the melting point is less than 5°C, the peak on the high melting point side and the peak on the lower melting point side are overlapped into one, and therefore thermal bondability of the fibers becomes unable to be effectively utilized.

In the polyethylene-based conjugate fibers, if a difference in a Vicat softening point between the first component and the second component is 15°C or more, thermocompression bonding processability by heat rolls is satisfactory, and therefore such a case is preferred. The difference is further preferably 20°C or more in which the range of adjusting physical properties of the nonwoven-fabric can be increased, and still further preferably 25°C or more.

As a method of stretching the polyethylene-based fibers of the invention, publicly known heat roll stretching or hot water stretching can be applied, but heat is uniformly transferred to tows to facilitate stretching, and stretching can be made at a high ratio by applying hot water stretching. Moreover, as a method of crimping the fibers, a publicly known mechanically-crimping means with a stuffer box can be applied. For the polyethylene-based fibers of the invention, a publicly known antistatic agent, fiber finishing agent and so forth can be appropriately used when necessary in a step of spinning or stretching the polyethylene-based fibers. In addition, such agents cause an increase in impurities eluted from the polyethylene-based fibers, and therefore are required to be washed and removed by water or an organic solvent. Therefore, the antistatic agent and the fiber finishing agent that can be easily dropped from the polyethylene-based fibers are desirably used. The step of washing and removing the agents described above is not particularly limited, but preferably performed after processing the fibers into the nonwoven fabric or into a product in order to suppress mixing of a deteriorated product or the like.

The polyethylene-based fibers of the invention are cut short by an ordinary method, before applying carding, into crimped staple fibers, and can be preferably used as the raw material of the nonwoven fabric. A length of the staple fibers to be applied as the raw material of the nonwoven fabric is not particularly limited, but is generally 25 to 125 millimeters, and preferably 38 to 64 millimeters. Specific examples of the nonwoven fabric include a so-called spunlace nonwoven fabric prepared by entangling fibers in a web by a high-pressure water flow, a point bonded nonwoven fabric prepared by passing a web through a space between a pair of heated embossing rolls and a flat roll to allow point bonding of fiber contacts by so-called point bonding processing according to which point bonding of the web is performed, a calendered nonwoven fabric prepared by passing a web through a space between a flat roll and a flat roll to perform thermocompression bonding, and a nonwoven fabric embossed after the spunlace processing described above, all of which exhibit soft texture and high drapability, and can be preferably used.

The polyethylene-based fibers of the invention have satisfactory thermobonding properties, and therefore can be preferably used in through-air processing in which the web is processed by hot air at a high temperature. As a method of preparing the web to which the through-air processing is applied, an air-laid process in which the web is formed by air flow, a paper-making process in which the web is formed by dispersing the fibers into an aqueous solution, or the like can be applied, in addition to carding. A length of the fibers used as the raw material in the air-laid process or the paper-making process is not particularly limited, but is preferably 2 to 25 millimeters. As the length of the fibers is smaller, the fibers are superb in processability. However, a larger fiber length is advantageous in order to improve strength of the nonwoven fabric obtained by thermally bonding the web. Accordingly, a fiber length can be appropriately selected in consideration of a balance between processability upon forming the web, and physical properties such as the strength of the nonwoven fabric.

The polyethylene-based fibers of the invention have satisfactory thermal bonding properties by the heat roll. Therefore, physical properties such as a thickness and strength of the nonwoven fabric can be adjusted by processing the fibers into the nonwoven fabric by through-air processing, and then passing the nonwoven fabric through a space between a pair of heated flat rolls, or between an embossing roll and the flat roll. When the nonwoven fabric is used as a filter material, a filter medium is hard to deform and a fill volume can be increased. A clearance of the pair of heat rolls, an embossing area ratio, temperature and so forth are not particularly limited. However, in the case of the polyethylene-based conjugate fibers, if a heat roll temperature is equal to or lower than the Vicat softening point of the first component and equal to or higher than the Vicat softening point of the second component, heat roll processability is satisfactory, and therefore such a case is preferred.

In the conjugate fibers described above, an additive may be blended within the range in which elution from polyethylene, being advantageous effects of the invention, is not adversely affected. Specific examples of the additives include an antioxidant and a weather-resistant agent.

The polyethylene-based fibers of the invention are not particularly limited, but can be preferably used as the fibers that constitute a liquid filtration filter used in a process of manufacturing a semiconductor. A form of the filter is not particularly limited, either, and specific examples of the form include a flat membrane-shaped filter prepared by laminating a nonwoven fabric composed of polyethylene-based fibers of the invention, a wind filter prepared by cylindrically winding fibers or a nonwoven fabric, a depth filter prepared by cylindrically winding fibers or a nonwoven fabric, and then bonding components among the fibers by heat treatment, and a pleated filter prepared by pleating a nonwoven fabric, and then cylindrically shaping the resulting material. In the polyethylene-based fibers of the invention, the total of content of the metal elements such as Na, K, Ca, Fe, Cu, Mg, Mn, Li, Al, Cr, Ni and Zn is 40 ppm or less, and therefore the amount of elution of the metal elements into a filter filtrate can be reduced to a significantly low level, poorness of a photoresist pattern can be suppressed, or electric characteristics and reliability of a final semiconductor product can be improved. Moreover, an application field of the liquid filtration filter is not particularly limited, either, and the filter can be preferably used in a manufacturing process in which mixing of the metal elements is unacceptable, such as a process of manufacturing a medicine or a battery electrolyte, in addition to the process of manufacturing the semiconductor.

The polyethylene-based fibers of the invention are not particularly limited, but can be preferably used as the fibers that constitute the nonwoven fabric being the material for the medical product. Polyethylene causes no deterioration of strength by exposure to radiation and has flexibility, and therefore can be used as a scrub suit, a covering cloth set, a childbirth pad, a cap, a mask, sheets, an antibacterial mat, a first-aid outfit (gauze, first-aid adhesive plaster), an absorbent article (diaper, napkin) or the like. The polyethylene-based fibers of the invention have a content of the metal elements as significantly small as 40 ppm or less, and the characteristics are favored in the medical field in which high-level reliability on cleanliness is required.

### Examples

Examples described below are merely for illustrative purposes only. A scope of the invention is not limited to the present Examples.

Methods of measuring physical properties and definitions thereof indicated in Examples are as described below.

### Strength at break and elongation at break of fibers and nonwoven fabrics

Strength at break and elongation at break of fibers were measured in accordance with JIS L1015 7.7.1.

Strength at break of a nonwoven fabric was measured by using Autograph AG-500D made by Shimadzu Corporation. A nonwoven fabric having 15 cm in MD and 5 cm in CD as a sample in measuring MD strength at break, and a nonwoven fabric having 5 cm in MD and 15 cm in CD in measuring CD strength at break were clamped with two air chucks adjusted to an interval of 100 mm, and strength at break of each nonwoven fabric when the nonwoven fabric was pulled downward at a speed of 200 m/min was measured. In addition, MD and CD herein mean a machine direction of the nonwoven fabric and a direction perpendicular thereto, respectively.

### Vicat softening point

A Vicat softening point was measured in accordance with JIS K7206.

### Processability of fibers

With regard to carding processability, a web upon charging about 40 g of fibers into a miniature carding machine was observed, and the processability was judged based on the evaluation criteria described below.

Good: a uniform web was obtained without causing a nep.

Marginal: a uniform web was unobtainable.

Poor: a web output from the carding machine was cut, and therefore the web was unable to be collected, or a nep was caused.

With regard to air-laid processability, a web upon charging fibers into an air-laid processing machine at about 60 g/min was observed, and the processability was judged based on the evaluation criteria described below.

Good: a uniform web was obtained.

Poor: a uniform web was unobtainable.

With regard to paper-making processability, about 30 g/m² of a web prepared by charging 2 g of fibers into water was observed, and the processability was judged based on the evaluation criteria described below.

Good: a uniform web was obtained.

Poor: a uniform web was unobtainable.

### Heat roll processability

When a heat-treated nonwoven fabric was passed through a space between heat rolls, the nonwoven after passing therethrough was observed, and heat roll processability was judged based on the evaluation criteria described below.

Good: a uniform nonwoven fabric was obtained, in which peeling from rolls was satisfactory.

Marginal: a uniform nonwoven fabric was unobtainable, in which peeling from rolls was difficult or wrinkles and so forth were produced.

Poor: a nonwoven fabric was unable to be collected, in which the nonwoven fabric was hard to peel from rolls or had low strength.

### Elution test on metallic components

While an ultrasonic wave was applied to a nonwoven fabric in an ultrasonic cleaner, the nonwoven fabric was immersed into isopropyl alcohol for 15 minutes, and rinsed twice by ultrapure water. Next, the nonwoven fabric was immersed into 5 wt% hydrochloric acid for 15 minutes and rinsed twice by ultrapure water, and further immersed into ultrapure water for 15 minutes, and then dried naturally. Then, 0.3 g of the nonwoven fabric was collected, 8 mL of nitric acid and 0.5 mL of hydrochloric acid were added thereto, and microwave decomposition was performed. The resulting material was diluted by ultrapure water into 90 g, and ICP-MS analysis and ICP-AES analysis were conducted. A content of metal elements each such as Na, K, Ca, Fe, Cu, Mg, Mn, Li, Al, Cr, Ni and Zn was totalized, and the content (content proportion) of the metal element based on polyethylene-based fibers was calculated.

### Example 1

An unstretched yarn composed of a single component and having 10 d/f (11.11 dtex/f) was obtained by extruding polyethylene having an MFR of 12 g/10 min (metallocene polyethylene Creolex T701A, made by Asahi Kasei Corporation, density: 0.966 g/cm³, melting point: 133°C) from a spinneret having a pore diameter of 0.8 mm ϕ at 250°C, and winding the resulting fibers at a spinning speed of 677 m/min. The unstretched yarn was stretched 5.0 times by using a hot-water stretching apparatus filled with hot water at 90°C, and then crimped into a zigzag form by an indent crimper. The resulting crimped tow was dried at 90°C and then cut to obtain 51 mm-long fibers. Fineness of the fibers obtained was 2.2 d/f (2.44 dtex/f), strength at break was 3.3 g/d (2.91 cN/dtex), elongation at break was 61%, and the number of crimps was 13.2 peaks/inch (5.20 peaks/cm). Carding processability of the fibers was satisfactory.

### Example 2

An unstretched yarn having 10 d/f (11.11 dtex/f) was obtained by extruding, as a core component, polyethylene having an MFR of 12 g/10 min (metallocene polyethylene Creolex T701A, made by Asahi Kasei Corporation, density: 0.966 g/cm³, melting point: 133°C, Vicat softening temperature: 127°C) at 250°C, and as a sheath component, polyethylene having an MFR of 12 g/10 min (metallocene polyethylene Harmolex NJ744N, made by Japan Polyethylene Corporation, density: 0.911 g/cm³, melting point: 120°C, Vicat softening temperature: 90°C) at 230°C from a spinneret having a sheath-core ratio of 50/50 and a pore diameter of 0.8 mm ϕ, and winding the resulting fibers at a spinning speed of 677 m/min. The unstretched yarn was stretched 5.0 times by using a hot-water stretching apparatus filled with hot water at 90°C, and then crimped into a zigzag form by an indent crimper. The resulting crimped tow was dried at 90°C and then cut to obtain 51 mm-long fibers. Fineness of the fibers obtained was 2.2 d/f (2.44 dtex/f), strength at break was 2.8 g/d (2.47 cN/dtex), elongation at break was 75%, and the number of crimps was 14.5 peaks/inch (5.71 peaks/ cm). Carding processability of the fibers was satisfactory.

### Example 3

An unstretched yarn having 10 d/f (11.11 dtex/f) was obtained by extruding, as a core component, polyethylene having an MFR of 12 g/10 min (metallocene polyethylene Creolex T701A, made by Asahi Kasei Corporation, density: 0.966 g/cm³, melting point: 133°C, Vicat softening temperature: 127°C) at 250°C, and as a sheath component, polyethylene having an MFR of 20 g/10 min (Tosoh Corporation, Nipolon-L, M70K (use of a Ziegler-Natta catalyst), density: 0.936 g/cm³, melting point: 124°C, Vicat softening point: 111°C) at 230°C from a spinneret having a sheath-core ratio of 50/50 and a pore diameter of 0.8 mm ϕ, and winding the resulting fibers at a spinning speed of 677 m/min. The unstretched yarn was stretched 4.0 times by using a hot-water stretching apparatus filled with hot water at 90°C, and then crimped into a zigzag form by an indent crimper. The resulting crimped tow was dried at 90°C and then cut to obtain 51 mm-long fibers. Fineness of the fibers obtained was 2.8 d/f (3.11 dtex/f), strength at break was 2.1 g/d (1.85 cN/dtex), elongation at break was 70%, and the number of crimps was 14.8 peaks/inch (5.83 peaks/cm). Carding processability of the fibers was satisfactory.

### Example 4

Fibers were obtained in a manner similar to Example 2 except that points described below were changed.

A finishing agent for air-laid processing was adhered thereon, and a cut length of fibers was changed to 6 mm. Air-laid processability of the fibers was satisfactory.

### Example 5

Fibers were obtained in a manner similar to Example 2 except that points described below were changed.

Fibers were not crimped, onto which a wet-type dispersing agent was adhered, a tow was not dried, and a cut length of the fibers was changed to 5 mm. Paper-making processability of the fibers was satisfactory.

### Example 6

Fibers were obtained in a manner similar to Example 2 except that points described below were changed.

An unstretched yarn wound at a spinning speed of 270 m/min and having 25 d/f (27.78 dtex/f) was stretched 5.5 times into a cut length of 64 mm. Fineness of the fibers obtained was 5.5 d/f (6.11 dtex/f), strength at break was 2.9 g/d (2.56 cN/dtex), elongation at break was 97%, and the number of crimps was 13.5 peaks/inch (5.31 peaks/cm). Carding processability of the fibers was satisfactory.

### Example 7

Through-air processing (at 125°C, conveyer speed: 8.5 m/min) was applied to a carded web prepared by blending 20 wt% of polyethylene fibers A having fineness of 16 d/f (17.78 dtex/f) and a fiber length of 64 mm (metallocene polyethylene, Harmolex, NJ744N, made by Japan Polyethylene Corporation, density: 0.911 g/cm³, melting point: 120°C, Vicat softening temperature: 90°C), and 80 wt% of the fibers described in Example 1, and then embossing was applied thereto at a temperature of 121°C, a linear pressure of 20 kg/cm and a speed of 10.0 m/min by flat rolls. Strength at break of the resulting nonwoven fabric having 50 g/m² was 3.3 kg/5 cm in MD and 0.5 kg/5 cm in CD.

### Example 8

Through-air processing (at 125°C, conveyer speed: 8.5 m/min) was applied to a carded web using the fibers described in Example 2, and then embossing was further applied thereto at a temperature of 121°C, a linear pressure of 20 kg/cm and a speed of 10.0 m/min by embossing rolls having a convex area proportion of 4%. Strength at break of the resulting nonwoven fabric having 30 g/m² was 5.3 kg/5 cm in MD and 1.0 kg/5 cm in CD.

### Example 9

A nonwoven fabric was prepared in a manner similar to Example 8 except that the fibers described in Example 3 were used.

### Example 10

A nonwoven fabric was prepared by using a carded web using the fibers described in Example 2 into a spunlace nonwoven fabric, and then applying through-air processing (at 125°C, conveyer speed: 8.5 m/min) thereto.

### Example 11

A nonwoven fabric was prepared in a manner similar to Example 8 except that an air-laid web using the fibers described in Example 4 was used.

### Example 12

A nonwoven fabric was prepared in a manner similar to Example 8 except that paper was made by using the fibers described in Example 5.

### Example 13

Through-air processing (at 125°C, conveyer speed: 8.5 m/min) was applied to a carded web using the fibers described in Example 6, and then embossing was further applied thereto at a temperature of 121°C, a linear pressure of 20 kg/cm and a speed of 10.0 m/min by embossing rolls having a convex area proportion of 25%. Strength at break of the resulting nonwoven fabric having 30 g/m² was 6.8 kg/5 cm in MD and 1.7 kg/5 cm in CD.

### Comparative Example 1

An unstretched yarn having 10 d/f (11.11 dtex/f) was obtained by extruding, as a core component, polyethylene having an MFR of 17 g/10 min (Keiyo Polyethylene Co., Ltd., M6900, density: 0.956 g/cm³, melting point: 132°C, Vicat softening temperature: 121°C) at 250°C, and as a sheath component, polyethylene having an MFR of 20 g/10 min (Tosoh Corporation, Nipolon-L, M70 (use of a Ziegler-Natta catalyst), density: 0.936 g/cm³, melting point: 120°C, Vicat softening point: 111°C) at 230°C from a spinneret having a sheath-core ratio of 50/50 and a pore diameter of 0.8 mm ϕ, and winding the resulting fibers at a spinning speed of 677 m/min. The unstretched yarn was stretched 5.0 times by using a hot-water stretching apparatus filled with hot water at 90°C, and then crimped into a zigzag form by an indent crimper. The resulting crimped tow was dried at 90°C and then cut to obtain 51 mm-long fibers. Fineness of the fibers obtained was 2.2 d/f (2.44 dtex/f), strength at break was 2.8 g/d (2.47 cN/dtex), elongation at break was 75%, and the number of crimps was 14.5 peaks/inch (5.71 peaks/cm). Carding processability of the fibers was satisfactory.

### Comparative Example 2

An unstretched yarn having 10 d/f (11.11 dtex/f) was obtained by extruding, as a core component, polyethylene having an MFR of 40 g/10 min (Japan Polyethylene Corporation, Novatec HD (use of a Ziegler-Natta catalyst), HJ590N, density: 0.960 g/ cm³, melting point: 133°C, Vicat softening temperature: 122°C) at 250°C, and as a sheath component, polyethylene having an MFR of 20 g/10 min (Tosoh Corporation, Nipolon-L, M70 (use of a Ziegler-Natta catalyst), density: 0.936 g/cm³, melting point: 120°C, Vicat softening point: 111°C) at 230°C from a spinneret having a sheath-core ratio of 50/50 and a pore diameter of 0.8 mm ϕ, and winding the resulting fibers at a spinning speed of 677 m/min. The unstretched yarn was stretched 5.0 times by using a hot-water stretching apparatus filled with hot water at 90°C, and then crimped into a zigzag form by an indent crimper. The resulting crimped tow was dried at 90°C and then cut to obtain 51 mm-long fibers. Fineness of the fibers obtained was 2.2 d/f (2.44 dtex/f), strength at break was 2.8 g/d (2.47 cN/dtex), elongation at break was 75%, and the number of crimps was 14.5 peaks/inch (5.71 peaks/cm). Carding processability of the fibers was satisfactory.

### Comparative Example 3

A nonwoven fabric was prepared in a manner similar to Example 8 except that the fibers described in Comparative Example 1 were used.

### Comparative Example 4

A nonwoven fabric was prepared in a manner similar to Example 8 except that the fibers described in Comparative Example 2 were used.

When the fibers described in Comparative Examples were used, peeling properties after passing through the heat rolls were poor, and a uniform nonwoven fabric was unobtainable. However, when the fibers described in Examples were used, a nonwoven fabric having high nonwoven fabric strength and uniformity was able to be obtained.

**Table 1**

| | Reference Example 1 | Example 2 | Reference Example 3 | Example 4 | Example 5 | Example 6 | Comparative Example 1 | Comparative Example 2 |
|---|---|---|---|---|---|---|---|---|
| Sheath component | | LLDPE | LLDPE | LLDPE | LLDPE | LLDPE | LLDPE | LLDPE |
| MFR g/10 min | | 12 | 20 | 12 | 12 | 12 | 20 | 20 |
| Density g/cm³ | | 0.911 | 0.936 | 0.911 | 0.911 | 0.911 | 0.936 | 0.936 |
| Melting point °C | | 120 | 124 | 120 | 120 | 120 | 120 | 120 |
| Vicat softening temperature °C | | 90 | 111 | 90 | 90 | 90 | 111 | 111 |
| Core component | HDPE | HDPE | HDPE | HDPE | HDPE | HDPE | HDPE | HDPE |
| MFR g/10 min | 12 | 12 | 12 | 12 | 12 | 12 | 17 | 40 |
| Density g/cm³ | 0.966 | 0.966 | 0.966 | 0.966 | 0.966 | 0.966 | 0.956 | 096 |
| Melting point °C | 133 | 133 | 133 | 133 | 133 | 133 | 132 | 133 |
| Vicat softening temperature °C | 127 | 127 | 127 | 127 | 127 | 127 | 121 | 122 |
| Sheath-core weight ratio | 50/50 | 50/50 | 50/50 | 50/50 | 50/50 | 50150 | 50150 | 50/50 |
| Sheath/core spinning temperature °C | 250 | 230/250 | 230/250 | 230/250 | 230/250 | 230/250 | 230/250 | 230/250 |
| Spinning speed m/min | 677 | 677 | 677 | 677 | 677 | 270 | 677 | 677 |
| Unstretched yarn fineness dlf | 10 | 10 | 10 | 10 | 10 | 25 | 10 | 10 |
| Hot-water stretching temperature °C | 90 | 90 | 90 | 90 | 90 | 90 | 90 | 90 |
| Stretch ratio | 5.0 | 5.0 | 4.0 | 5.0 | 5.0 | 5.5 | 5 | 5 |
| Drying temperature °C | 90 | 90 | 90 | 90 | - | 90 | 90 | 90 |
| Cut length mm | 51 | 51 | 51 | 6 | 5 | 64 | 51 | 51 |
| Stretched yarn fineness d/f | 2.2 | 2.2 | 2.8 | 2.2 | 2.2 | 5.5 | 2.2 | 2.2 |
| Strength at break g/d | 33 | 2.8 | 2.1 | 2.8 | 28 | 2.9 | 2.8 | 2.8 |
| Elongation at break % | 61 | 75 | 70 | 75 | 75 | 97 | 75 | 75 |
| Processability of fibers | Good | Good | Good | Good | Good | Good | Good | Good |
| Metal content ppm | 7 | 13 | 25 | 13 | 13 | 13 | 86 | 115 |
| Number of crimps peaks/m (peaks/inch) | 520 (13.2) | 571 (14.5) | 583 (14.8) | 413 (10.5) | - | 531 (13.5) | 571(14.5 ) | 571 (14.5) |

**Table 2**

| | Example 7 | Example 8 | Example 9 | Example 10 | Example 11 | Example 12 | Example 13 | Comparative Example 3 | Comparative Example 4 |
|---|---|---|---|---|---|---|---|---|---|
| Use fibers 1 | Described in Example 1 | Described in Example 2 | Described in Example 3 | Described in Example 2 | Described in Example 4 | Described in Example 5 | Described in Example 6 | Described in Comparative Example 1 | Described in Comparative Example 2 |
| Use fibers 2 | Fiber A | - | - | - | - | - | - | - | - |
| 1 and 2 mixing weight ratio | 80/20 | - | - | - | - | - | - | - | - |
| Processing method | Carding | Carding | Carding | - | Air laid | Paper making | Carding | Carding | Carding |
| Spunlace | - | - | - | Existence | - | - | - | - | - |
| Heat treatment | Air through | Air through | Air through | Air through | Air through | Air through | Air through | Air through | Air through |
| Heat treatment temperature °C | 125 | 125 | 125 | 125 | 125 | 125 | 125 | 125 | 125 |
| Heat roll processing | Flat | 4% Emboss | 4% Emboss | - | 4% Emboss | 4% Emboss | 25% Emboss | 4% Emboss | 4% Emboss |
| Roll processing temperature °C | 121 | 121 | 121 | - | 121 | 121 | 121 | 121 | 121 |
| Heat roll processability | Good | Good | Good | - | Good | Good | Good | Marginal | Marginal |
| Nonwoven fabric basis weight g/m² | 50 | 30 | 30 | 50 | 30 | 30 | 30 | 30 | 30 |
| Nonwoven fabric MD strength Kg/5cm | 3.3 | 5.3 | 4.1 | 3.7 | 3.9 | 4.5 | 6.8 | 3.8 | 3 |
| Nonwoven fabric CD strength Kg/5cm | 0.5 | 1.0 | 0.7 | 0.6 | 3.7 | 4.2 | 1.7 | 0.4 | 0.7 |

### Industrial Applicability

In polyethylene-based fibers of the invention, elution of metal can be significantly reduced, and therefore the polyethylene-based fibers can be preferably used as a raw material in a filter application. In particular, the polyethylene-based fibers can be preferably used in an application of a filter medium used in a field of IC or the like and a medicine. Further, the polyethylene-based fibers of the invention and a nonwoven fabric using the same causes no deterioration of strength by exposure to radiation and have flexibility, and therefore can be widely and preferably used as a medical article such as a scrub suit, a covering cloth set, a childbirth pad, a cap, a mask, sheets and an antibacterial mat, an absorbent article (disposable diaper, napkin), a first-aid outfit (gauze, first-aid adhesive plaster), and a hygiene product article such as a toiletry (wet tissue, cosmetic cotton). Moreover, when the polyethylene-based fibers obtained by the invention are conjugate fibers, the conjugate fibers have thermobonding properties. Therefore, a fiber aggregate can also be obtained by thermally bonding the polyethylene-based fibers with fibers that are not substantially melted at temperature at which the polyethylene-based fibers are melted, such as cellulosic fibers including rayon and pulp, polyester fibers, acrylic fibers or the like.

## Claims

1. Polyethylene-based fibers, **characterized in that** the polyethylene-based fibers are sheath-core conjugate fibers composed of polyethylene resin, wherein
a core component thereof is composed of a polyethylene resin having a density of 0.94 g/cm³ or more,
a sheath component thereof is composed of a polyethylene resin having a density of 0.90 g/cm³ or more,
the density of the core component is higher than the density of the sheath component,
polyethylene resins produced by polymerization using a metallocene catalysts are used as raw materials of the polyethylene-based fibers,
in case linear law density polyethylene is used, a resin having density of 0.900 g/cm³ or more and less than 0.940 g/cm³ and a melting point of lower than 127 °C is used,
a total of content of metal elements such as Na, K, Ca, Fe, Cu, Mg, Mn, Li, Al, Cr, Ni and Zn contained inside the fibers is 40 ppm or less, and
a melt flow rate as measured in accordance with JIS K7210 (190 °C, 2160g) of the core component and the sheath component of the sheath-core conjugate fibers are in a range of 10 g/10 min to 40 g/10 min.

2. The polyethylene-based fibers according to claim 1, wherein a difference in a melting point between the core component and the sheath component is 5°C or more.

3. The polyethylene-based fibers according to claim 1 or 2, being staple fibers having crimps.

4. A liquid filtration filter comprising the polyethylene-based fibers according to any one of claims 1 to 3.

5. A medical product comprising a nonwoven fabric constituted by the polyethylene-based fibers according to any one of claims 1 to 3.

6. A nonwoven fabric, being **characterized in that** the nonwoven fabric comprises the polyethylene-based fibers according to any one of claims 1 to 3.

## Patentansprüche

1. Fasern auf Polyethylenbasis, **dadurch gekennzeichnet, dass** die Fasern auf Polyethylenbasis konjugierte Mantel-Kern-Fasern sind, die aus Polyethylenharz zusammengesetzt sind, wobei
eine Kernkomponente davon aus einem Polyethylenharz, aufweisend eine Dichte von 0,94 g/cm³ oder mehr, zusammengesetzt ist,
eine Mantelkomponente davon aus einem Polyethylenharz, aufweisend eine Dichte von 0,90 g/cm³ oder mehr, zusammengesetzt ist,
wobei die Dichte der Kernkomponente höher ist als die Dichte der Mantelkomponente,
Polyethylenharze, die durch Polymerisation unter Verwendung eines Metallocen-Katalysators hergestellt werden, als Rohmaterialen der Fasern auf Polyethylenbasis verwendet werden,
falls Polyethylen mit linearer Dichte verwendet wird, ein Harz, aufweisend eine Dichte von 0,900 g/cm³ oder mehr und weniger als 0,940 g/cm³ und einen Schmelzpunkt von weniger als 127 °C verwendet wird,
ein Gesamtgehalt an Metallelementen wie Na, K, Ca, Fe, Cu, Mg, Mn, Li, Al, Cr, Ni und Zn, die in den Fasern enthalten sind, 40 ppm oder weniger beträgt, und
eine gemäß JIS K7210 (190 °C, 2160 g) gemessene Schmelzflussrate der Kernkomponente und der Mantelkomponente der konjugierten Mantel-Kern-Fasern in einem Bereich von 10 g/10 min bis 40 g/10 min liegt.

2. Fasern auf Polyethylenbasis gemäß Anspruch 1, wobei ein Unterschied in einem Schmelzpunkt zwischen der Kernkomponente und der Mantelkomponente 5°C oder mehr beträgt.

3. Fasern auf Polyethylenbasis gemäß einem der Ansprüche 1 bis oder 2, die Stapelfasern mit Kräuselung sind.

4. Flüssigkeitsfiltrationsfilter, umfassend die Fasern auf Polyethylenbasis gemäß einem der Ansprüche 1 bis 3.

5. Medizinisches Produkt, umfassend einen Vliesstoff, der aus den Fasern auf Polyethylenbasis gemäß einem der Ansprüche 1 bis 3 zusammengesetzt ist.

6. Vliesstoff, **dadurch gekennzeichnet, dass** der Vliesstoff die Fasern auf Polyethylenbasis gemäß einem der Ansprüche 1 bis 3 umfasst.

## Revendications

1. Fibres à base de polyéthylène, **caractérisées en ce que** les fibres à base de polyéthylène sont des fibres de conjugué gaine-coque composé de résine de polyéthylène,
un de ses composants de coque étant composé d'une résine de polyéthylène ayant une densité de 0,94 g/cm³ ou plus,
un de ses composants de gaine étant composé d'une résine de polyéthylène ayant une desité de 0,90 g/cm³ ou plus,
la densité du composant de coque étant supérieure à la densité du composant de gaine,
les résines de polyéthylène produites par polymérisation en utilisant des catalyseurs de métallocène étant utilisées comme matière brutes des fibres à base de polyéthylène,
dans le cas où du polyéthylène de densité à loi linéaire est utilisé, une résine ayant une densité de 0,900 g/cm³ ou plus et de moins de 0,940 g/cm³ et un point de fusion de moins de 127 °C est utilisée,
un total de la teneur en éléments métalliques tels que Na, K, Ca, Fe, Cu, Mg, Mn, Li, Al, Cr, Ni et Zn contenus à l'intérieur des fibres est de 40 ppm ou moins et
un débit à chaud tel que mesuré selon la norme JIS K7210 (190 °C, 2160 g) du composant de coque et du composant de gaine des fibres du conjugué gaine-coque se situent dans une plage allant de 10 g/10 min à 40 g/10 min.

2. Fibres à base de polyéthylène selon la revendication 1, dans lesquelles une différence dans un point de fusion ente le composant de coque et le composant de gaine est de 5 °C ou plus.

3. Fibres à base de polyéthylène selon la revendication 1 ou 2, étant des fibres d'agrafe ayant des crans.

4. Filtre de filtration liquide comprenant les fibres à base de polyéthylène selon l'une quelconque des revendications 1 à 3.

5. Produit médical comprenant un textile non tissé constitué par les fibres de polyéthylène selon l'une quelconque des revendications 1 à 3.

6. Textile non tissé, étant **caractérisé en ce que** le textile non tissé comprend les fibres à base de polyéthylène selon l'une quelconque des revendications 1 à 3.
